(19) Europäisches Patentamt / European Patent Office / Office européen des brevets

(11) **EP 4 693 375 A1**

(12) **EUROPEAN PATENT APPLICATION**
published in accordance with Art. 153(4) EPC

(43) Date of publication:
**11.02.2026 Bulletin 2026/07**

(21) Application number: **24780034.5**

(22) Date of filing: **22.03.2024**

(51) International Patent Classification (IPC):
*H01L 21/304* (2006.01)   *C09G 1/02* (2006.01)
*C09K 3/14* (2006.01)

(52) Cooperative Patent Classification (CPC):
**C09G 1/02; C09K 3/14; H01L 21/304**

(86) International application number:
**PCT/JP2024/011420**

(87) International publication number:
**WO 2024/203916 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.03.2023 JP 2023056599**

(71) Applicant: **Fujimi Incorporated
Kiyosu-shi, Aichi 452-8502 (JP)**

(72) Inventors:
• **ITO, Yasuaki**
  **Kiyosu-shi, Aichi 452-8502 (JP)**
• **NAKAGAI, Yuichiro**
  **Kiyosu-shi, Aichi 452-8502 (JP)**

(74) Representative: **Grünecker Patent- und
Rechtsanwälte
PartG mbB
Leopoldstraße 4
80802 München (DE)**

(54) **POLISHING COMPOSITION**

(57)   Provided is a polishing composition that can improve a polishing removal rate. The polishing composition contains resin particles and an oxidant in which the oxidant contains a composite metal oxide and the concentration of organic particles is 0.01% by weight or more.

EP 4 693 375 A1

**Description**

[Technical Field]

The present invention relates to a polishing composition.
The application claims the priority based on Japanese Patent Application No. 2023-56599, filed on March 30, 2023, the content of which is herein incorporated by reference in its entirety.

[Background Art]

A surface of a material such as metal, semimetal, non-metal, or an oxide thereof has been polished with a polishing composition. For example, a surface formed of a compound semiconductor material, such as silicon carbide, boron carbide, tungsten carbide, silicon nitride, titanium nitride, or gallium nitride is processed by polishing (lapping), which is performed by supplying a diamond abrasive between the surface and a polishing platen. However, lapping with a diamond abrasive is prone to generate defects and strains due to generated or remaining scratches or dents, or the like. For this reason, exploration has been made for polishing with a polishing pad and a polishing composition, after lapping with a diamond abrasive or instead of such lapping. Examples of literatures disclosing this kind of conventional technique include Patent Literature 1.

[Citation List]

[Patent Literature]

[Patent Document 1] WO2016/072370

[Summary of Invention]

[Technical Problem]

Generally, a polishing removal rate is required to be practically, sufficiently high in view of manufacturing efficiency, cost-effectiveness, and the like. For example, polishing of a surface formed of a high hardness material such as silicon carbide has strongly required an improved polishing removal rate. For the purpose of improving a polishing removal rate in polishing of a substrate or the like made of such a high hardness material, it is effective to chemically degenerate a surface to be polished and makes it fragile, in addition to using an abrasive having a physical polishing function. In anticipation of such an effect, a polishing composition may be prepared with containing an oxidant. For example, Patent Document 1 has proposed a polishing composition that contains an abrasive, water, and an oxidant such as potassium permanganate and is used in polishing of a substrate made of a high hardness material.
In polishing of various objects to be polished including a substrate made of a high hardness material as described above, it is practically significant to enable providing a higher level of a polishing removal rate.
The present invention was made in light of such circumstances, and has an objective to provide a polishing composition that can achieve an excellent polishing removal rate for an object to be polished.

[Solution to Problem]

The inventors found that a polishing composition with resin particles contributes to improvement in a polishing removal rate.
The polishing composition provided hereby contains resin particles and an oxidant, wherein the oxidant contains a composite metal oxide and the resin particles are contained in an amount of 0.01% by weight or more. Such a polishing composition can improve a polishing removal rate.

[Description of Embodiments]

Preferred embodiments of the present invention will be described below. Incidentally, matters that are other than those particularly mentioned in the present specification but are necessary for implementation of the present invention can be recognized by those skilled in the art as design matters based on the conventional art in the relevant field. The present invention can be implemented based on contents disclosed in the present specification and common general technical knowledge in the field.

<Polishing Composition>

(Resin Particles)

The polishing composition disclosed herein contains resin particles. The polishing composition with resin particles can achieve a higher polishing removal rate. The term "resin particles" as used herein refers to particles containing organic matter. In some preferred embodiments, the resin particles are particles that contain organic matter as a main component. The term "main component" as used herein refers to a component occupying more than 50% by weight of the total. The resin particles can have a solubility of 5 g/100 mL or less in water at 25°C.

The resin particles is preferably formed of polymer containing carbon as a main component. A material forming the resin particles may be a thermoplastic resin or a thermosetting resin. Examples of the thermoplastic resin include an universal resin and an engineering resin. Examples of the universal resin include polyolefin resins such as polyethylene, polypropylene, polybutene, polyisobutylene, and polymethylpentene; polyethylene-vinyl acetate resins; acrylic resins such as polymethyl acrylate (PMA), polymethyl methacrylate (PMMA), polymethacrylic acid, and polyacrylic acid; styrene resins; styrene-acrylic resins; saturated polyester resins such as polyethylene terephthalate (PET); and vinyl chloride resins. The engineering resin may be an universal engineering resin or a super engineering resin. Examples of the universal engineering resin include polyamide resins such as nylon and aramide; polyacetal resins; and polycarbonate resins. Examples of the super engineering resin include fluorine reins such as polytetrafluoroethylene (PTFE); polysulfone resins; polyether sulfone (PES) resins; and thermoplastic polyimide resins. Examples of the thermosetting resin include phenol resins; melamine resins; amino resins; epoxy resins; urea resins; unsaturated polyester resins; polyurethane resins; acrylic-urethane resins; thermosetting polyimide resins; benzoguanamine resins; and silicone resins. As the resin particles, resin particles substantially formed of any of the aforementioned resins can be used. The resin particles may be used as a single kind or in combination of two or more kinds thereof. In particular, more preferred are polyolefin resins, acrylic resins, styrene-acrylic resins, vinyl chloride resins, melamine resins, polyurethane resins, and acrylic-urethane resins, even more preferred are styrene-acrylic resins and acrylic resins, and particularly preferred are acrylic resins. In an embodiment with use of an acrylic resin as the resin particles, the art disclosed herein can be applied to preferably exert an effect to improve a polishing removal rate.

Note that "substantially consisting of X" or "substantially formed of X" for the composition of the resin particles herein means that the proportion of X in the resin particles (purity of X) is 90% or more on a weight basis. The proportion of X in the resin particles is preferably 95% or more, more preferably 97% or more, even more preferably 98% or more, and e.g., 99% or more.

The resin particles may be charged particle, or uncharged particle. As the resin particles, any of anionic, cationic, nonionic, or amphoteric particles can be used. On a surface of the resin particles, at least one kind of functional group selected from an anionic functional group, a cationic functional group, an amphoteric functional group, or a non-ionic functional group may be introduced. Examples of the anionic functional group include a carboxylic acid type, a sulfonic acid type, a sulfate ester type, and a phosphoric ester type, and examples of the cationic functional group include an amine salt type and a quaternary ammonium salt. Examples of the amphoteric functional group include an alkanolamide type, a carboxy betaine type, and a glycine type, and examples of the non-ionic functional group include an ether type and an ester type.

In addition, a resin as a material forming the resin particles may either be a resin (cross-linked resin) having a cross-linked form derived by mixing and reacting a main agent (base resin) and a curative agent, or a resin having no cross-linking (non-cross-linked resin). Examples of the main agent for use include the resins as described above (e.g., acrylic resin). Examples of the curing agent for use include, but are not limited to, epoxy compounds and isocyanate compounds. In some embodiments, a material forming the resin particles is a cross-linked acrylic resin or a non-cross-linked acrylic resin. In some other embodiments, a material forming the resin particles is a cross-linked styrene-acrylic resin or a non-cross-linked styrene-acrylic resin.

As the resin particles, a substance prepared with use of a known method may be used, or a substance having a particle diameter, a shape, a property, and the like preferred as an abrasive for polishing an object to be polished such as a substrate can be selected and used among commercially-available products obtainable from various manufacturers. For example, acrylic resin particles can be selected and used among commercially available products obtainable from Nippon Paint Co., Ltd., DIC Corporation, Aica Kogyo Company, Limited, Nippon Shokubai Co., Ltd. and the like. Styrene resin particles can be selected and used among commercially available products obtainable from Nippon Paint Co., Ltd. and the like. Styrene-acrylic resin particles can be selected and used among commercially available products obtainable from Nippon Shokubai Co., Ltd., Nippon Paint Co., Ltd. and the like. Nylon resin particles can be selected and used among commercially available products obtainable from Toray Industries, Inc. and the like. Epoxy resin particles can be selected and used among commercially available products obtainable from Toray Industries, Inc. and the like. Saturated polyester resin particles can be selected and used among commercially available products obtainable from Unitika Ltd., Sekisui Kasei Co., Ltd., and the like. Polyurethane resin particles can be selected and used among commercially available products obtainable from Aica Kogyo Company, Limited, Negami Chemical Industrial Co., Ltd., and the like. Phenol resin particles can be selected and used among commercially available products obtainable from Air Water Inc., Sumitomo Bakelite Co., Ltd., and the like. Melamine resin particles and benzoguanamine resin particles can be selected and used among commercially available products obtainable from Nippon Shokubai Co., Ltd. and the like. PES resin particles can be selected and used among commercially available products obtainable from Japan Material Technologies Corporation and the like. PTFE resin particles can be selected and used among commercially available products obtainable from Techno Chemical Corporation and the like. These resin particles may be used as a single kind or in combination of two or more kinds thereof.

The average particle diameter of the resin particles may be e.g., 0.001 $\mu$m or more, and in view of facilitating improvement in a polishing removal rate, preferably 0.005 $\mu$m or more, more preferably 0.01 $\mu$m or more, and may be 0.015 $\mu$m or more, or 0.02 $\mu$m or more. The upper limit of the average particle diameter of the resin particles is suitably approximately 10 $\mu$m or less in view of sufficiently ensuring the number per unit weight. Meanwhile, in view of improving a polishing removal rate, the average particle diameter is preferably 5 $\mu$m or less, more preferably 3 $\mu$m or less, e.g., 2 $\mu$m or less, 1.5 $\mu$m or less, or 1 $\mu$m or less. In view of further improving a polishing removal rate, the average particle diameter of the resin particles in some embodiments may be 0.06 $\mu$m or less, 0.05 $\mu$m or less, 0.04 $\mu$m or less, or 0.03 $\mu$m or less.

A method of measuring the average particle diameter of the resin particles is not particularly limited, and a suitable known method can be used corresponding to a particle diameter. As the average particle diameter of the resin particles, a value measured by dynamic light scattering can be exemplarily employed. Meanwhile, in use of commercially-available resin particles, a manufacturer's nominal value (catalogue value) can be employed as the average particle diameter of the resin particles.

The polishing composition disclosed herein contains 0.01% by weight or more of the resin particles. In view of enhancing an effect of use of the resin particles, in some embodiments, the content of the resin particles in the polishing composition may be 0.015% by weight or more, 0.02% by weight or more, 0.03% by weight or more, 0.04% by weight or more, or 0.05% by weight or more. The content of the resin particles in the polishing composition disclosed herein is, in view of stability of the polishing composition and the like, suitably less than 10% by weight, and may be less than 6% by weight, preferably less than 3% by weight, more preferably less than 2% by weight, and may be less than 1.5% by weight, 1.3% by weight or less, 1.2% by weight or less, 1.1% by weight or less, or 1% by weight or less. In some embodiments, the content of the resin particles in the polishing composition may be 0.5% by weight or less or less than 0.5% by weight, 0.2% by weight or less or less than 0.2% by weight, 0.15% by weight or less or less than 0.15% by weight, 0.1% by weight or less or less than 0.1% by weight, 0.05% by weight or less or less than 0.05% by weight, 0.04% by weight or less or less than 0.04% by weight, 0.03% by weight or less or less than 0.03% by weight, or 0.02% by weight or less or less than 0.02% by weight. When the polishing composition disclosed herein contains various kinds of resin particles, the content of the resin particles in the polishing composition refers to the total content of the various kinds of resin particles.

(Inorganic Particles)

The polishing composition disclosed herein may contain inorganic particles as far as an effect of the present invention is not significantly prevented. With containing inorganic particles, the polishing composition can lead to exertion of a mechanical polishing function, thereby achieving a higher polishing removal rate.

The material, properties, and the like of the inorganic particles are not particularly limited. Examples thereof include inorganic particles substantially formed of any of the following: oxide particles such as silica particles, alumina particles, cerium oxide particles, chromium oxide particles, titanium dioxide particles, zirconium oxide particles, magnesium oxide particles, manganese dioxide particles, zinc oxide particles, and iron oxide particles; nitride particles such as silicon nitride particles and boron nitride particles; carbide particles such as silicon carbide particles and boron carbide particles; diamond particles; and carbonates such as calcium carbonate and barium carbonate. The inorganic particles may be used as a single kind or in combination of two or more kinds thereof. In particular, preferred are oxide particles such as silica particles, alumina particles, cerium oxide particles, chromium oxide particles, zirconium oxide particles, manganese dioxide particles, and iron oxide particles, because of their ability to form a good surface. Specifically, more preferred are silica particles, alumina particles, zirconium oxide particles, chromium oxide particles, and iron oxide particles, even more preferred are silica particles and alumina particles and particularly preferred is alumina particles. In an embodiment with use of alumina particles as the inorganic particles, the art disclosed herein can be applied to preferably exert an effect to improve a polishing removal rate.

Note that "substantially consisting of X" or "substantially formed of X" for the composition of the inorganic particles herein means that the proportion of X in the inorganic particles (purity of X) is 90% or more on a weight basis. The proportion of X in the inorganic particles is preferably 95% or more, more preferably 97% or more, even more preferably 98% or more, and e.g., 99% or more.

The average primary particle diameter of the inorganic particles is not particularly limited. In view of improving a polishing removal rate, the average primary particle diameter of the inorganic particles can be e.g., 5 nm or more, is suitably 10 nm or more, preferably 20 nm or more, and may be 30 nm or more. In view of further improving a polishing removal rate, the average primary particle diameter of the inorganic particles in some embodiments may be 50 nm or more, 80 nm or more, 150 nm or more, 250 nm or more, or 350 nm or more. Meanwhile, in view of a post-polishing surface quality and the like, the average primary particle diameter of the inorganic particles can be, e.g., 5 $\mu$m or less, preferably 3 $\mu$m or less, more preferably 1 $\mu$m or less, and may be 750 nm or less, or 500 nm or less. In view of further improving a post-polishing surface quality and the like, the average primary particle diameter of the inorganic particles in some embodiments may be 350 nm or less, 180 nm or less, 85 nm or less, or 50 nm or less.

An average primary particle diameter, as used herein, refers to a particle diameter (BET particle diameter) calculated from a specific surface area measured by a BET method (BET value) by the formula: average primary particle diameter (nm) = $6000/(\text{true density (g/cm}^3) \times \text{BET value (m}^2/\text{g}))$. The specific surface area can be measured using e.g., a surface area measurement device with the product name of "Flow Sorb II 2300", manufactured by Micromeritics Instrument Corporation.

The average secondary particle diameter of the inorganic particles may be e.g., 10 nm or more, and in view of facilitating enhancement of a polishing removal rate, preferably 50 nm or more, more preferably 100 nm or more, and may be 250 nm or more, or 400 nm or more. The upper limit of the average secondary particle diameter of the inorganic particles is suitably approximately 10 $\mu$m or less in view of sufficiently ensuring the number per unit weight. Furthermore, in view of a post-polishing surface quality and the like, the average secondary particle diameter is preferably 5 $\mu$m or less, more preferably 3 $\mu$m or less, and e.g., 1 $\mu$m or less. In view of further improving a post-polishing surface quality, the average secondary particle diameter of the inorganic particles in some embodiments may be 600 nm or less, 300 nm or less, 170 nm or less, or 100 nm or less.

The average secondary particle diameter of the inorganic particles can be measured, for particles having a size of less than 500 nm, as the volume average particle diameter (arithmetic average diameter by volume; Mv) by dynamic light scattering, using, e.g., model "UPA-UT151" manufactured by Nikkiso Co., Ltd. Particles having a size of 500 nm or more can be measured as the volume average particle diameter by an aperture electrical resistance method or the like using model "Multisizer 3" manufactured by Beckman Coulter Inc.

In use of alumina particles as the inorganic particles, the alumina particles can be appropriately selected and used from various known alumina particles. Examples of such known alumina particles include $\alpha$-alumina and intermediate alumina. Intermediate alumina herein refers to a collective designation of alumina particles other than $\alpha$-alumina, and specific examples include $\gamma$-alumina, $\delta$-alumina, $\theta$-alumina, $\eta$-alumina, $\kappa$-alumina, and $\chi$-alumina. Alumina referred to as fumed alumina in accordance with classification by production methods (typically, alumina microparticles produced in high-temperature firing of alumina salt) may also be used. Furthermore, alumina referred to as colloidal alumina or alumina sol (e.g., alumina hydrate such as boehmite) is also included in examples of the known alumina particles. In view of processability, it is preferred to contain $\alpha$-alumina. Inorganic particles in the art disclosed herein can contain such alumina particles as a single one species or in combination of two or more kinds.

In use of alumina particles as the inorganic particles, it is generally advantageous that the proportion of the alumina particles in inorganic particles to be used be higher. For example, the proportion of the alumina particles in the total inorganic particles is preferably 70% by weight or more, more preferably 90% by weight or more, and yet more preferably 95% by weight or more, and may be substantially 100% by weight.

The particle size of the alumina particles is not particularly limited, and can be selected so as to exert a desired polishing effect. In view of improving a polishing removal rate and the like, the average primary particle diameter of the alumina particles is preferably 50 nm or more, more preferably 80 nm or more, and may be 150 nm or more, 250 nm or more, or 300 nm or more. The upper limit of the average primary particle diameter of the alumina particles is not particularly limited, and is, in view of a post-polishing surface quality and the like, suitably roughly 5 $\mu$m or less. In view of further improving a post-polishing surface quality and the like, the upper limit is preferably 3 $\mu$m or less, more preferably 1 $\mu$m or less, and may be 750 nm or less or 500 nm or less.

In use of alumina particles as the inorganic particles, the polishing composition disclosed herein may further contain inorganic particles formed of a material other than the alumina described above (hereinafter also referred to as non-alumina particles) as far as an effect of the present invention is not impaired. Examples of such non-alumina particles include inorganic particles substantially formed of any of the following: oxide particles such as silica particles, cerium oxide particles, chromium oxide particles, titanium dioxide particles, zirconium oxide particles, magnesium oxide particles, manganese oxide particles, zinc oxide particles, and iron oxide particles; nitride particles such as silicon nitride particles and boron nitride particles; carbide particles such as silicon carbide particles and boron carbide particles; diamond particles; and carbonates such as calcium carbonate and barium carbonate.

The content of the non-alumina particles is suitably, e.g., 30% by weight or less, preferably 20% by weight or less, more preferably 10% by weight or less in the total weight of inorganic particles contained in the polishing composition.

In a preferred embodiment in the art disclosed herein, the polishing composition contains silica particles as the inorganic particles. The silica particles can be appropriately selected and used from various known silica particles. Examples of such known silica particles include colloidal silica and dry silica. In particular, use of colloidal silica is preferred.

Silica particles containing colloidal silica can preferably achieve a good surface smoothness.

The shape (outer shape) of the silica particles may be globular or non-globular. Specific examples of the silica particles having non-globular forms include peanut-shaped (i.e., peanut shell-shaped) particles, cocoon-shaped particles, conpeito-shaped particles, and rugby ball-shaped particles. In the art disclosed herein, the silica particles may take a form of primary particles or a form of secondary particles formed by aggregation of a plurality of primary particles. The silica particles may contain a mixture of a form of primary particles and a form of secondary particles. In preferred embodiments, at least a part of the silica particles is contained in a form of secondary particles in the polishing composition.

As the silica particles, particles with an average primary particle diameter of more than 5 nm can be preferably employed. In view of a polishing removal rate and the like, the average primary particle diameter of the silica particles is, preferably 15 nm or more, more preferably 20 nm or more, even more preferably 25 nm or more, particularly preferably 30 nm or more. The upper limit of the average primary particle diameter of the silica particles is not particularly limited, and suitably roughly 120 nm or less, preferably 100 nm or less, more preferably 85 nm or less. For example, in view of balancing a polishing removal rate and a surface quality with a higher level, preferred are silica particles with an average primary particle diameter of 12 nm or more and 80 nm or less, and preferred are silica particles with an average primary particle diameter of 15 nm or more and 75 nm or less.

The average secondary particle diameter of the silica particles is not particularly limited, and is, in view of a polishing removal rate and the like, preferably 20 nm or more, more preferably 50 nm or more, even more preferably 70 nm or more. Meanwhile, in view of providing a surface with a higher quality, the average secondary particle diameter of the silica particle is 500 nm or less, preferably 300 nm or less, more preferably 200 nm or less, even more preferably 130 nm or less, particularly preferably 110 nm or less (e.g., 100 nm or less).

The absolute specific gravity (absolute density) of the silica particles is preferably 1.5 or more, more preferably 1.6 or more, and even more preferably 1.7 or more. Increase in the absolute specific gravity of the silica particles leads to a tendency to a higher physical ability for polishing. The upper limit of the absolute specific gravity of the silica particles is not particularly limited, and is typically 2.3 or less, and e.g., 2.2 or less, 2.0 or less, or 1.9 or less. As the absolute specific gravity of the silica particles, a measured value derived by liquid replacement using ethanol as a replacing liquid can be employed.

The shape (outer shape) of the silica particles is preferably globular. Without particular limitation, the average value of the major axis/minor axis ratios of the particles (average aspect ratio) is theoretically 1.00 or more, and in view of improving a polishing removal rate, it may also be e.g., 1.05 or more or 1.10 or more. Moreover, the average aspect ratio of the particles is suitably 3.0 or less, and may be 2.0 or less. In view of improved smoothness, less scratching, and the like on a surface to be polished, the average aspect ratio of the particles is preferably 1.50 or less, and may be 1.30 or less, or 1.20 or less.

The shape (outer shape) and the average aspect ratio of the particles can be acquired by, e.g., electron microscopy. An exemplary specific procedure for acquiring the average aspect ratio can be as follows: with use of a scanning electron microscope (SEM), extracting the shapes of a predetermined number (e.g., 200) of particles; drawing a minimum rectangle circumscribed to each of the extracted shapes of particles; then calculating, as a major axis/minor axis ratio (aspect ratio), a value by dividing the long side length (major axis value) by the short side length (minor axis value) for the rectangle drawn for each of the shapes of particles; and deriving the average aspect ratio from an arithmetic average of the aspect ratios for the predetermined number of the particles.

In an embodiment in which the polishing composition contains silica particles, the polishing composition may further contain inorganic particles formed of a material other than silica (hereinafter also referred to as non-silica particles). Specific examples of such non-silica particles include particles substantially formed of any of oxide particles such as alumina particles, cerium oxide particles, chromium oxide particles, titanium dioxide particles, zirconium oxide particles, magnesium oxide particles, manganese oxide particles, zinc oxide particles, and iron oxide particles; nitride particles such as silicon nitride particles and boron nitride particles; carbide particles such as silicon carbide particles and boron carbide particles; diamond particles; and carbonate salts such as calcium carbonate and barium carbonate.

The content of the non-silica particles is suitably, e.g., 30% by weight or less, preferably 20% by weight or less, more preferably 10% by weight or less in the total weight of inorganic particles contained in the polishing composition.

The content of inorganic particles in the polishing composition disclosed herein is, in view of a post-polishing surface quality, suitably less than 50% by weight, and may be less than 40% by weight, preferably less than 30% by weight, more preferably less than 25% by weight, and may be less than 10% by weight, 9% by weight or less, 8% by weight or less, 7% by weight or less, or 6% by weight or less. In some embodiments, the content of inorganic particles in the polishing composition may be 0.5% by weight or less or less than 0.5% by weight, 0.1% by weight or less or less than 0.1% by weight, 0.05% by weight or less or less than 0.05% by weight, or 0.04% by weight or less or less than 0.04% by weight.

The lower limit of the content of inorganic particles in the polishing composition disclosed herein is not particularly limited, and can be, e.g., 0.000001% by weight or more (i.e., 0.01 ppm or more). In view of enhancing an effect of use of inorganic particles, the content of inorganic particles in the polishing composition in some embodiments may be 0.00001% by weight or more, 0.0001% by weight or more, 0.001% by weight or more, 0.002% by weight or more, or 0.005% by weight or more. In some embodiments, the content of inorganic particles in the polishing composition may be 0.01% by weight or more, 0.02% by weight or more, 0.03% by weight or more, more than 0.1% by weight, more than 0.3% by weight, 0.5% by weight or more, or 0.8% by weight or more.

When the polishing composition disclosed herein contains a plurality kinds of inorganic particles, the content of inorganic particles in the polishing composition refers to the total content of the plurality kinds of inorganic particles.

Preferably, the polishing composition disclosed herein does not substantially contain diamond particles as the particles. Diamond particles have a high hardness and thus can be a factor for limited improvement in smoothness. Diamond particles are also generally expensive and thus not necessarily an advantageous material in terms of cost performance, and there may be less dependence on high-price materials such as diamond particles in terms of practical use. The particles not substantially containing diamond particles, in this context, means that the proportion of diamond particles in all the particles contained in the polishing composition is 1% by weight or less, more preferably 0.5% by weight or less, and typically 0.1% by weight or less, including a case where the proportion of diamond particles is 0% by weight. In such an embodiment, an effect by applying the present invention can be preferably exerted.

When the polishing composition contains inorganic particles, a relation between the content of inorganic particles and the content of resin particles is not particularly limited, and can be appropriately set so as to achieve a desired effect corresponding to a purpose of use, an embodiment of use, and the like. The ratio of the content of resin particles Wrp [% by weight] relative to the content of inorganic particles Wip [% by weight], i.e., Wrp/Wip, can be, e.g., approximately 0.001 or more, suitably 0.0025 or more, and may be 0.003 or more, 0.004 or more, or 0.005 or more. Wrp/Wip is not too large, leading to a tendency to avoid generating too high frictional force and to be suitable for polishing. In some embodiments, Wrp/Wip may be 0.01 or more or 0.02 or more.

In the polishing composition containing inorganic particles, the upper limit of Wrp/Wip is not particularly limited, and in view of preservation stability of the polishing composition, can be, e.g., approximately 5000 or less, and may be 1500 or less, 1000 or less, 800 or less, 400 or less, 250 or less, 100 or less, 80 or less, or 40 or less. In some embodiments, Wrp/Wip may be 30 or less, 20 or less, 10 or less, 5 or less, or 1 or less.

In the "Wrp/Wip" described above, "Wrp" represents a numerical value part in indication of the content of resin particles in the polishing composition by a unit "% by weight"; "Wip" represents a numerical value part in indication of the content of inorganic particles in the polishing composition by a unit "% by weight"; and both Wrp and Wip are dimensionless numbers.

(Oxidant)

The polishing composition disclosed herein contains an oxidant. The oxidant is effective for reducing hardness of a material to be polished (e.g., a non-oxide material having high hardness such as silicon carbide) and making the material fragile. The oxidant can thus exert an effect to improve a polishing removal rate in polishing of a material to be polished. In the specification, the oxidant do not encompass the metal salt described later.

The polishing composition disclosed herein is characterized by containing a composite metal oxide as the oxidant. A composition containing a composite metal oxide as the oxidant facilitates improvement in polishing performance. The composite metal oxide can be used as a single kind or in combination of two or more kinds. Examples of the composite metal oxide include ferrites, permanganates, chromates, vanadates, ruthenates, molybdates, perrhenates, and tungstates. In particular, more preferred are ferrites, permanganates, chromates, vanadates, molybdates, and tungstates, and even more preferred are permanganates and vanadates. The composite metal oxide thus contained may be a composite transition metal oxide that is a salt of a cation selected from alkali metal ions and an anion selected from transition metal oxoacid ions. Specific examples of a transition metal oxoacid ion in the composite transition metal oxide include a permanganate ion, a ferrite ion, a chromate ion, a dichromate ion, a vanadate ion, a ruthenate ion, a molybdate ion, a rhenate ion, and a tungstate ion. In particular, more preferred are oxo acids of transition metal elements belonging to period 4 in the periodic table. Preferred examples of the transition metal elements belonging to period 4 in the periodic table include Fe, Mn, Cr, V, and Ti. In particular, more preferred are Fe, Mn, Cr, and V, and even more preferred are Mn and V. An alkali metal ion in the composite transition metal oxide is preferably $Na^+$ or $K^+$. In some embodiments, sodium permanganate, potassium permanganate, and sodium metavanadate can be preferably employed as the oxidant.

The content of an oxidant in the polishing composition is not particularly limited, and can be appropriately set so as to achieve a desired effect corresponding to a purpose of use, an embodiment of use, and the like of the polishing composition. In some embodiments, in view of improving a polishing removal rate, the content of the oxidant is suitably, approximately 0.5% by weight or more. In view of improving a polishing removal rate, the content of the oxidant is preferably 1% by weight or more, more preferably 1.4% by weight or more. In some embodiments, the content of an oxidant may be 2.7% by weight or more, 4% by weight or more, 6% by weight or more, 6.5% by weight or more, 8% by weight or more, 9% by weight or more, 10% by weight or more, 15% by weight or more, 20% by weight or more, or 22% by weight or more. Meanwhile, in some embodiments, the content of the oxidant in the polishing composition is suitably, approximately 45% by weight or less, preferably 40% by weight or less, more preferably 35% by weight or less, even more preferably 30% by weight or less, and may be 25% by weight or less, 20% by weight or less, 15% by weight or less, or 10% by weight or less.

The polishing composition disclosed herein may or may not further contain an oxidant other than a composite metal oxide (hereinafter also referred to as "another oxidant"). Specific examples of a compound to be an option of another oxidant include peroxides such as hydrogen peroxide; periodic acid and salts thereof, i.e., periodates, such as sodium periodate and potassium periodate; iodic acid and salts thereof, i.e., iodates, such as ammonium iodate; bromic acid and salts thereof, i.e., bromates, such as potassium bromate; persulfuric acid such as peroxosulfuric acid, and peroxodisulfuric acid and salts thereof, i.e., persulfates, such as ammonium persulfate and potassium persulfate; chloric acid and salts thereof, perchloric acid and salts thereof, i.e., chromates and perchromates, such as potassium perchromate; osmates such as perosmic acid and osmic acid; selenates such as perselenic acid and selenic acid; and cerium ammonium nitrate. As another oxidant, such compounds can be used as a single kind or in combination of two or more kinds. In some embodiments, in view of performance stability of the polishing composition (e.g., prevention of deterioration due to long-term preservation) and the like, another oxidant is preferably an inorganic compound.

When a compound used as an oxidant is salt (e.g., permanganate), the compound may be present in form of an ion in the polishing composition.

In the polishing composition disclosed herein, a relation between the content of an oxidant and the content of resin particles is not particularly limited, and can be appropriately set so as to achieve a desired effect corresponding to a purpose of use, an embodiment of use, and the like. The ratio of the content of an oxidant $Wx$ [% by weight] to the content of resin particles $Wrp$ [% by weight], i.e., $Wx/Wrp$, can be, e.g., approximately 0.1 or more, is suitably 0.25 or more, may be 0.5 or more, 1 or more, 2 or more, 5 or more, or 10 or more. Larger $Wx/Wrp$ tends to be accompanied by larger contribution of chemical polishing relative to contribution of mechanical polishing. In some embodiments, $Wx/Wrp$ may be 50 or more, 60 or more, further 65 or more, 100 or more, 150 or more, or 200 or more.

In the polishing composition disclosed herein, the upper limit of $Wx/Wrp$ is not particularly limited, and in view of preservation stability of the polishing composition, it can be, e.g., approximately 5000 or less, and may be 1500 or less, 1000 or less, 800 or less, 400 or less, 300 or less, 200 or less, 100 or less, or 75 or less. In some embodiments, $Wx/Wrp$ may be 50 or less, 40 or less, or 30 or less.

In the "$Wx/Wrp$" described above, "$Wx$" represents a numerical value part in indication of the content of an oxidant in the polishing composition by a unit "% by weight"; "$Wrp$" represents to a numerical value part in indication of the content of resin particles in the polishing composition by a unit "% by weight"; and both $Wx$ and $Wrp$ are dimensionless numbers.

In an embodiment in which the polishing composition contains inorganic particles, a relation between the content of an oxidant and the content of inorganic particles is not particularly limited, and can be appropriately set so as to achieve a desired effect corresponding to a purpose of use, an embodiment of use, and the like. The ratio of the content of an oxidant $Wx$ [% by weight] to the content of inorganic particles $Wip$ [% by weight], i.e., $Wx/Wip$, can be, e.g., approximately 0.001 or more, is suitably 0.002 or more, may be 0.005 or more, 0.01 or more, 0.02 or more, or 0.1 or more, and may be 0.15 or more, preferably 0.2 or more, more preferably 0.3 or more. Larger $Wx/Wip$ tends to be accompanied by larger contribution of chemical polishing relative to contribution of mechanical polishing. In some embodiments, $Wx/Wip$ may be 0.5 or more, or 0.6 or more.

In the polishing composition disclosed herein, the upper limit of $Wx/Wip$ is not particularly limited, and in view of preservation stability of the polishing composition, it can be, e.g., approximately 20 or less, and may be 15 or less, 10 or less, 5 or less, 3 or less, 2 or less, 1 or less, 0.8 or less, or 0.7 or less.

In the "$Wx/Wip$" described above, "$Wx$" represents a numerical value part in indication of the content of an oxidant in the polishing composition by a unit "% by weight"; "$Wip$" represents a numerical value part in indication of the content of inorganic particles in the polishing composition by a unit "% by weight"; and both $Wx$ and $Wip$ are dimensionless numbers.

(Metal Salt)

The polishing composition disclosed herein may contain a metal salt. Use of the metal salt facilitates better improvement in a polishing removal rate. Use of the metal salt also facilitates preventing the polishing composition from deterioration of performance (e.g., reduction in a polishing removal rate). As the metal salt, one or more kinds of Metal salt A, Metal salt B, and Metal salt C described later can be selected.

(Metal Salt A)

In some preferred embodiments, the polishing composition contains Metal salt A selected from alkaline-earth metal salts. As Metal salt A, one kind of alkaline-earth metal salt may be used singly, or two or more kinds of alkaline-earth metal salts may be used in combination. Use of Metal salt A can improve a polishing removal rate. Metal salt A preferably contains any one kind or two or more kinds of Mg, Ca, Sr, and Ba as an element belonging to alkaline-earth metal. In particular, preferred is either of Ca or Sr, and more preferred is Ca.

The kind of a salt in Metal salt A is not particularly limited, and may be an inorganic acid salt or an organic acid salt. Examples of the inorganic acid salt include salts of hydrohalic acid such as hydrochloric acid, hydrobromic acid, and hydrofluoric acid; nitric acid; sulfuric acid; carbonic acid; silicic acid; boric acid; and phosphoric acid. Examples of the organic acid salt include salts of carboxylic acids such as formic acid, acetic acid, propionic acid, benzoic acid, glycine acid, butyric acid, citric acid, tartaric acid, and trifluoroacetic acid; organic sulfonic acids such as methanesulfonic acid, trifluoromethanesulfonic acid, benzenesulfonic acid, and toluenesulfonic acid; organic phosphonic acids such as methylphosphonic acid, benzenephosphonic acid, and toluenephosphonic acid; and organic phosphoric acid such as ethylphosphoric acid. In particular, preferred are salts of hydrochloric acid, nitric acid, sulfuric acid, and phosphoric acid, and more preferred are salts of hydrochloric acid and nitric acid. The art disclosed herein can be preferably implemented e.g., in an embodiment with use of a nitrate or chloride of an alkaline-earth metal as Metal salt A.

Specific examples of an alkaline-earth metal salt to be a potential option of Metal salt A include chlorides such as magnesium chloride, calcium chloride, strontium chloride, and barium chloride; bromides such as magnesium bromide, calcium bromide, strontium bromide, and barium bromide; fluorides such as magnesium fluoride, calcium fluoride, strontium fluoride, and barium fluoride; nitrates such as magnesium nitrate, calcium nitrate, strontium nitrate, and barium nitrate; sulfates such as magnesium sulfate, calcium sulfate, strontium sulfate, and barium sulfate; carbonates such as magnesium carbonate, calcium carbonate, strontium carbonate, and barium carbonate; carboxylates such as magnesium acetate, calcium acetate, strontium acetate, barium acetate, magnesium benzoate, calcium benzoate, barium benzoate, magnesium citrate, calcium citrate, strontium citrate, and barium citrate.

Metal salt A is preferably a water-soluble salt. Use of Metal salt A with water solubility can efficiently form a good surface with less defects such as a scratch.

Metal salt A is also preferably a compound not to be oxidized by an oxidant. Appropriate selection of an oxidant and Metal salt A in such a view allows avoiding deactivation of the oxidant due to oxidization of Metal salt A by the oxidant, and preventing the polishing composition from age-related deterioration of performance (e.g., reduction in a polishing removal rate). In such a view, calcium nitrate is preferred as Metal salt A.

When the polishing composition contains Metal salt A, the concentration (content) of Metal salt A in the polishing composition is not particularly limited, and can be appropriately set so as to achieve a desired effect, corresponding to a purpose of use, an embodiment of use, and the like of the polishing composition. The concentration of Metal salt A may be, e.g., approximately 1000 mM or less (i.e., 1 mole/L or less), 500 mM or less, or 300 mM or less. In some embodiments, the concentration of Metal salt A is suitably 200 mM or less, preferably 100 mM or less, more preferably 50 mM or less, and may be 30 mM or less, 20 mM or less, or 10 mM or less. The lower limit of the concentration of Metal salt A may be, e.g., 0.1 mM or more, and in view of appropriately exerting an effect of use of Metal salt A, it is preferably 0.5 mM or more, more preferably 1 mM or more, and may be 2.5 mM or more, 5 mM or more, 10 mM or more, 20 mM or more, or 30 mM or more.

(Metal Salt B)

In some preferred embodiments, the polishing composition contains Metal salt B, which is selected from salts each of which has a cation containing a metal belonging to groups 3 to 16 in the periodic table and an anion. As Metal salt B, a metal salt selected from salts each of which has a cation containing a metal belonging to groups 3 to 16 in the periodic table and an anion, can be used as a single kind or in combination of two or more kinds. Use of Metal salt B can improve a polishing removal rate.

A cation of Metal salt B may be a cation containing a transition metal, i.e., a metal belonging to groups 3 to 12 in the periodic table, or a cation containing a poor metal, i.e., a metal belonging to groups 13 to 16. The transition metal is preferably a metal belonging to groups 4 to 11 in the periodic table, and also suitably a metal belonging to periods 4 to 6 in the periodic table, preferably a metal belonging to periods 4 to 5, more preferably a metal belonging to period 4. The poor metal is preferably a metal belonging to groups 13 to 15 in the periodic table, more preferably a metal belonging to groups 13 to 14, and also preferably a metal belonging to periods 3 to 5 in the periodic table, more preferably a metal belonging to periods 3 to 4, and particularly preferably a poor metal belonging to period 3, i.e., aluminum.

In some embodiments, Metal salt B is preferably a salt of a cation containing a metal whose hydrated metal ion has a pKa of approximately less than 7, and an anion. Metal salt B, which is a salt of such a cation and an anion, generates a hydrated metal cation in water, and the hydrated metal cation carries a proton on coordinated water being addition-elimination equilibrium and thus acts as a pH buffer, thereby facilitating prevention of deterioration of performance of the polishing composition due to a lapse of time. In such a view, a salt of a metal cation whose hydrated metal ion has e.g., a pKa of less than 7.0 or 6.0 or less, and an anion can be preferably employed as Metal salt B. Examples of a metal cation whose hydrated metal ion has a pKa of 6.0 or less include, but are not limited to, $Al^{3+}$ (whose hydrated metal ion has a pKa of 5.0), $Cr^{3+}$ (whose hydrated metal ion has a pKa of 4.2), $Fe^{3+}$ (whose hydrated metal ion has a pKa of 2.2), $ZrO^{2+}$ (whose hydrated metal ion has a pKa of -0.3), $Ga^{3+}$ (whose hydrated metal ion has a pKa of 2.6), and $In^{3+}$ (whose hydrated metal ion has a pKa of 4.0).

The kind of a salt in Metal salt B is not particularly limited, and may be an inorganic acid salt or an organic acid salt. Examples of the inorganic acid salt include salts of hydrohalic acid such as hydrochloric acid, hydrobromic acid, and hydrofluoric acid; nitric acid; sulfuric acid; carbonic acid; silicic acid; boric acid; and phosphoric acid. Examples of the organic acid salt include salts of carboxylic acids such as formic acid, acetic acid, propionic acid, benzoic acid, glycine acid, butyric acid, citric acid, tartaric acid, and trifluoroacetic acid; organic sulfonic acids such as methanesulfonic acid, trifluoromethanesulfonic acid, benzenesulfonic acid, and toluenesulfonic acid; organic phosphonic acids such as methylphosphonic acid, benzenephosphonic acid, and toluenephosphonic acid; and organic phosphoric acid such as ethylphosphoric acid. In particular, preferred are salts of hydrochloric acid, nitric acid, sulfuric acid, and phosphoric acid, and more preferred are salts of hydrochloric acid, nitric acid, and sulfuric acid. The art disclosed herein can be preferably implemented e.g., in an embodiment with use of a salt of any cation of $Al^{3+}$, $Cr^{3+}$, $Fe^{3+}$, $ZrO^{2+}$, $Ga^{3+}$, or $In^{3+}$ and a nitrate ion ($NO^{3-}$) or a chloride ion ($Cl^-$), as Metal salt B.

Metal salt B is preferably a water-soluble salt. Use of Metal salt B with water solubility can efficiently form a good surface with less defects such as a scratch.

The Metal salt B is also preferably a compound not to be oxidized by an oxidant. Appropriate selection of an oxidant and Metal salt B in such a view allows avoiding deactivation of the oxidant due to oxidization of Metal salt B by the oxidant, and preventing the polishing composition from age-related deterioration of performance (e.g., reduction in a polishing removal rate). In such a view, aluminum nitrate, aluminum chloride, and the like are preferred as Metal salt B.

When the polishing composition contains Metal salt B, the concentration (content) of Metal salt B in the polishing composition is not particularly limited, and can be appropriately set so as to achieve a desired effect, corresponding to a purpose of use, an embodiment of use, and the like of the polishing composition. The concentration of Metal salt B may be, e.g., approximately 1000 mM or less (i.e., 1 mole/L or less), 500 mM or less, or 300 mM or less. In some embodiments, the concentration of Metal salt B is suitably 200 mM or less, preferably 100 mM or less, more preferably 50 mM or less, and may be 40 mM or less, 35 mM or less, or 32 mM or less. The lower limit of the concentration of Metal salt B may be, e.g., 0.1 mM or more, and in view of appropriately exerting an effect of use of Metal salt B, it is preferably 1 mM or more, more preferably 10 mM or more (e.g., 15 mM or more), and may be 20 mM or more, or 25 mM or more.

(Metal Salt C)

In some preferred embodiments, the polishing composition contains Metal salt C selected from salts each of which has a cation containing a transition metal, i.e., a metal belonging to groups 3 to 12 in the periodic table, and an anion. Metal salt C can be used as a single kind or in combination of two or more kinds. When the polishing composition contains an oxidant, use of Metal salt C allows preventing the polishing composition from deterioration of performance (e.g., reduction in a polishing removal rate) due to pH change of the polishing composition in polishing of an object to be polished.

The transition metal preferably belongs to groups 4 to 11 in the periodic table, and also suitably belongs to periods 4 to 6 in the periodic table, preferably belongs to periods 4 to 5, more preferably belongs to period 4.

In some embodiments, Metal salt C is preferably a salt of a cation containing metal whose hydrated metal ion has a pKa of approximately less than 7, and an anion. Metal salt C, which is a salt of such a cation and an anion, generates a hydrated metal cation in water, and the hydrated metal cation carries a proton on coordinated water being addition-elimination equilibrium and thus acts as a pH buffer, thereby facilitating prevention of deterioration of performance of the polishing composition due to a lapse of time. In such a view, a salt of a cation containing a metal whose hydrated metal ion has e.g., a pKa of less than 7 or 6 or less, and an anion can be preferably employed as Metal salt C. Examples of a cation of a metal whose hydrated metal ion has a pKa of 6 or less include, but are not limited to, $Cr^{3+}$ (whose hydrated metal ion has a pKa of 4.2), $Fe^{3+}$ (whose hydrated metal ion has a pKa of 2.2), $Hf^{4+}$ (whose hydrated metal ion has a pKa of 0.2), $Zr^{4+}$ (whose hydrated metal ion has a pKa of -0.3), and $Ti^{4+}$ (whose hydrated metal ion has a pKa of -4.0).

Examples of a cation formed of Metal salt C include, but are not limited to, cations including single atom transition metal cations such as $Cr^{3+}$, $Fe^{3+}$, $Hf^{4+}$, $Zr^{4+}$, and $Ti^{4+}$; oxy transition metal cations such as $ZrO^{2+}$, $ZrO^+$, $HfO^+$, $TiO^+$, and $TiO^{2+}$; and transition metal hydroxide cations such as $ZrOH^+$ and $HfOH^+$.

The kind of a salt in Metal salt C is not particularly limited, and may be an inorganic salt or an organic salt. Examples of the inorganic salt include compounds including inorganic acid salts of hydrohalic acid such as hydrochloric acid, hydrobromic acid, and hydrofluoric acid, nitric acid, sulfuric acid, carbonic acid, silicic acid, boric acid, phosphoric acid, and the like; sulfides; oxides; oxyhalides such as oxychloride, oxybromide, and oxyfluoride; oxy-inorganic acid salts such as oxynitrate, oxysulfate, oxycarbonate, oxysilicate, oxyborate, and oxyphosphate; and oxysulfide. Examples of the organic salt include organic acid salts of carboxylic acids such as formic acid, acetic acid, propionic acid, benzoic acid, glycine acid, butyric acid, citric acid, tartaric acid, and trifluoroacetic acid; organic sulfonic acids such as methanesulfonic acid, trifluoromethanesulfonic acid, benzenesulfonic acid, and toluenesulfonic acid; organic phosphonic acids such as methylphosphonic acid, benzenephosphonic acid, and toluenephosphonic acid; organic phosphoric acid such as ethylphosphoric acid; and oxy-organic acid such as oxyacetic acid. In particular, preferred are salts of hydrochloric acid, nitric acid, sulfuric acid, and phosphoric acid, and more preferred are salts of hydrochloric acid, and nitric acid. The art disclosed herein can be preferably implemented e.g., in an embodiment of an oxy-transition metal salt, which is a salt of an oxy-transition metal cation and an anion, as Metal salt C. As some preferred embodiments, the art disclosed herein can be preferably implemented in an embodiment with use of a salt of any oxy-transition metal cation of $ZrO^{2+}$, $ZrO^+$, $HfO^+$, $TiO^+$,

or $TiO^{2+}$ and a nitrate ion ($NO^{3-}$), a sulfate ion ($SO_4^{2-}$) or a chloride ion ($Cl^-$).

Metal salt C dissolves in water and thereby generates a polynuclear transition metal complex formed of a transition metal and an oxygen atom and/or hydrogen. For example, when dissolved in water, Metal salt C such as zirconyl nitrate, zirconium sulfate, or zirconium chloride generates a polynuclear transition metal complex formed of zirconium and an oxygen atom and/or hydrogen. In the art disclosed herein, Metal salt C can also be preferably implemented in an embodiment of a polynuclear transition metal complex formed of a transition metal and an oxygen atom and/or hydrogen generated by dissolving itself in water. Examples of a preferred polynuclear transition metal complex include a polynuclear transition metal complex formed of zirconium and an oxygen atom and/or hydrogen.

Metal salt C is preferably a compound not to be oxidized by an oxidant. Appropriate selection of an oxidant and Metal salt C in such a view allows avoiding deactivation of the oxidant due to oxidization of Metal salt C by the oxidant, and preventing the polishing composition from age-related deterioration of performance (e.g., reduction in a polishing removal rate). In such a view, zirconyl nitrate and the like are preferred as Metal salt C.

When the polishing composition contains Metal salt C, the concentration (content) of Metal salt C in the polishing composition is not particularly limited, and can be appropriately set so as to achieve a desired effect, corresponding to a purpose of use, an embodiment of use, and the like of the polishing composition. The concentration of Metal salt C may be, e.g., approximately 1000 mM or less (i.e., 1 mole/L or less), 500 mM or less, or 300 mM or less. In some embodiments, the concentration of Metal salt C is suitably 200 mM or less, preferably 100 mM or less, more preferably 50 mM or less, and may be 30 mM or less, 20 mM or less, or 10 mM or less. When the polishing composition contains Metal salt C, the lower limit of the concentration of Metal salt C may be, e.g., 0.1 mM or more, and in view of appropriately exerting an effect of use of Metal salt C, it may be 1 mM or more, preferably 5 mM or more, more preferably 10 mM or more (e.g., 15 mM or more), and may be 18 mM or more, 20 mM or more, or 30 mM or more.

(Water)

The polishing composition disclosed herein contains water. Examples of water to be preferably used include ion-exchanged water (deionized water), pure water, ultrapure water, and distilled water. The polishing composition disclosed herein may further contain an organic solvent that can be uniformly mixed with water (lower alcohol, lower ketone, or the like), as appropriate. Usually, in a solvent(s) in the polishing composition, water accounts for 90% by volume or more, preferably 95% by volume, more preferably 99 to 100% by volume.

(Acid)

The polishing composition can contain an acid, as appropriate, in view of pH adjustment, improvement in a polishing removal rate, and the like. As the acid, any of inorganic acid or organic acid can be used. Examples of the inorganic acid include sulfuric acid, nitric acid, hydrochloric acid, and carbonic acid. Examples of the organic acid include aliphatic carboxylic acids such as formic acid, acetic acid, and propionic acid; aromatic carboxylic acids such as benzoic acid and phthalic acid; citric acid; oxalic acid; tartaric acid; malic acid; maleic acid; fumaric acid; succinic acid; organic sulfonic acid; and organic phosphonic acid. These can be used as a single kind or in combination of two or more kinds. In use of an acid, the usage thereof is not particularly limited and can be an usage corresponding to a purpose of use (e.g., pH adjustment). Alternatively, in some embodiments of the polishing composition disclosed herein, a composition may contain substantially no acid.

(Basic Compound)

The polishing composition can contain a basic compound, as appropriate, in view of pH adjustment, improvement in a polishing removal rate, and the like. A basic compound, as used herein, refers to a compound that is added to the polishing composition and thereby exerts a function to raise the pH of the composition. Examples of the basic compound include alkali metal hydroxides such as potassium hydroxide and sodium hydroxide; carbonate salts or hydrogen carbonate salts such as ammonium hydrogen carbonate, ammonium carbonate, potassium hydrogen carbonate, potassium carbonate, sodium hydrogen carbonate, and sodium carbonate; ammonia; quaternary ammonium compounds, e.g. quaternary ammonium hydroxides such as tetramethylammonium hydroxide, tetraethylammonium hydroxide, and tetrabutylammonium hydroxide; and other components such as amines, phosphate salts or hydrogen phosphate salts, and organic acid salts. The basic compound can be used as a single kind or in combination of two or more kinds. In use of a basic compound, the usage thereof is not particularly limited and can be an usage corresponding to a purpose of use (e.g., pH adjustment). Alternatively, in some embodiments of the polishing composition disclosed herein, a composition may contain substantially no basic compound.

(Other Components)

The polishing composition disclosed herein may further contain, as necessary, a known additive that can be used for a polishing composition (e.g., a polishing composition used for polishing a high hardness material such as silicon carbide), such as a chelator, a thickener, a dispersant, a surface protective agent, a wetting agent, a surfactant, a corrosion inhibitor, an antiseptic agent, or an antifungal agent, as far as an effect of the present invention is not impaired. Since the content of the additive only has to be appropriately set according to the purpose of addition thereof and does not characterize the present invention, a detailed description thereof will be omitted.

(pH)

The pH of the polishing composition is suitably about 1 to 12. The pH within the range facilitates achievement of a practical polishing removal rate. In some embodiments, the pH may be 12.0 or less, 11.0 or less, 10.0 or less, 9.0 or less, less than 9.0, 8.0 or less, less than 8.0, 7.0 or less, less than 7.0, or 6.0 or less. In presence of a metal salt, in view of facilitating more exertion of effects to improve a polishing removal rate by use of a metal salt (e.g., Metal salt B), the pH of the polishing composition in some embodiments is preferably less than 6.0, and may be 5.0 or less, less than 5.0, 4.0 or less, or less than 4.0. The pH may be, e.g., 1.0 or more, 1.5 or more, 2.0 or more, or 2.5 or more.
A preparation method of the polishing composition disclosed herein is not particularly limited. For example, a well-known mixing apparatus such as a blade stirrer, an ultrasonic disperser, or a homomixer can be used to mix each component included in the polishing composition. An embodiment of mixing these components is not particularly limited, and for example, all components may be mixed at a time or may be mixed in an order set appropriately.
The polishing composition disclosed herein may be a single-agent type or a multi-agent type such as a two-agent type. For example, the composition may be configured to mix Part A, which contains a part of components of the polishing composition (e.g., a component other than water), and Part B, which contains the remaining components and to be used for polishing of an object to be polished. The multi-agent type polishing composition may further contain Part C in addition to Part A and Part B as described above. These can be, e.g., separately stored before use and mixed together to prepare a one-component polishing composition in use. In the mixing, water for dilution and the like can be additionally mixed. In a preferred embodiment, a multi-component polishing composition disclosed herein contains resin particles and water in Part A, and contains an oxidant and water in Part B. Such an embodiment can provide the polishing composition with improved storage stability. Part C, which is optionally used, may or may not contain a part of resin particles, an oxidant, and the like.

<Object to be Polished>

An object to be polished of the polishing composition disclosed herein is not particularly limited. For example, the polishing composition disclosed herein can be applied to polishing of a substrate having a surface formed of a compound semiconductor material, i.e., a compound semiconductor substrate. A component material of the compound semiconductor substrate is not particularly limited, and examples thereof can include group II-VI compound semiconductors such as cadmium telluride, zinc selenide, cadmium sulfide, mercury cadmium telluride, and cadmium zinc telluride; group III-V compound semiconductors such as gallium nitride, gallium arsenide, gallium phosphide, indium phosphide, aluminum gallium arsenide, gallium indium arsenide, indium gallium arsenide nitride, aluminum gallium indium phosphide; group IV-IV compound semiconductors such as silicon carbide and germanium silicide. A plurality of these materials may form an object to be polished. In a preferred embodiment, the polishing composition disclosed herein can be applied to polishing of a substrate having a surface formed of a chemical semiconductor material other than oxides (i.e., a non-oxide). Polishing of a substrate having a surface formed of a non-oxide chemical semiconductor material is likely to lead to preferable exertion of an effect to promote polishing by an oxidant contained in the polishing composition disclosed herein.
The polishing composition disclosed herein can be preferably used for polishing e.g., a surface of an object to be polished having a Vickers hardness of 500 Hv or more. This Vickers hardness is preferably 700 Hv or more, e.g., 1000 Hv or more or 1500 Hv or more. The Vickers hardness of a material to be polished may be 1800 Hv or more, 2000 Hv or more, or 2200 Hv or more. The upper limit of the Vickers hardness of an object to be polished is not particularly limited, and may be e.g., approximately 7000 Hv or less, 5000 Hv or less, or 3000 Hv or less. Herein the Vickers hardness can be measured in accordance with JIS R 1610: 2003. The international standard corresponding to this standard in JIS is ISO 14705: 2000.
Examples of a material having a Vickers hardness of 1500 Hv or more include silicon carbide, silicon nitride, titanium nitride, and gallium nitride. An object to be polished in the art disclosed herein can have a single crystal surface of the aforementioned material, which is mechanically and chemically stable. In particular, a surface of an object to be polished is formed of preferably either of silicon carbide or gallium nitride, more preferably silicon carbide. Since silicon carbide is expected as a compound semiconductor substance material with less power loss, excellent heat resistance and the like, there is a particularly great advantage in improving productivity by enhancing a polishing removal rate. The art disclosed herein is particularly preferably applied to a single-crystal surface of silicon carbide.

<Polishing Method>

The polishing composition disclosed herein can be used for polishing of an object to be polished e.g., in an embodiment including the following operation.

In other words, a polishing slurry (slurry) containing any of the polishing compositions disclosed herein is provided. Provision of the polishing slurry may contain subjecting the polishing composition to operation such as concentration adjustment (e.g., dilution), pH adjustment, or the like, thereby preparing the polishing slurry. Alternatively, the polishing composition may be directly used as a polishing slurry. In the case of a multi-agent type polishing composition, preparation of the polishing slurry may include mixing the agents thereof, diluting one or more of the agents before the mixing, diluting the resulting mixture after the mixing, and the like.

Then, the polishing slurry is supplied to an object to be polished, and polishing is carried out by a common method performed by a person skilled in the art. An example thereof is a method of setting an object to be polished in a typical polishing machine, and then supplying the polishing slurry via a polishing pad of the polishing machine onto a surface to be polished of the object to be polished. Typically, while the polishing slurry is consecutively supplied, a polishing pad is pushed against a surface to be polished of an object to be polished and both are relatively moved (e.g., rotatably moved). Through such a polishing step, polishing of an object to be polished is completed.

Note that the aforementioned content (concentration) and content (concentration) ratio for each component that can be contained in the polishing composition in the art disclosed herein typically means the content and content ratio in the polishing composition in practical supply to an object to be polished (i.e., at a point of use), and therefore can be translated as the content and content ratio in the polishing slurry.

The specification provides a polishing method of polishing an object to be polished (typically, a material to be polished) and a method of producing a polished object using the polishing method. The polishing method is characterized by including a step of polishing an object to be polished using the polishing composition disclosed herein. A polishing method according to a preferred embodiment includes a step of performing stock polishing (stock polishing step) and a step of performing final polishing (final polishing step). In a typical embodiment, the stock polishing step is a polishing step set just before the final polishing step. The stock polishing step may be a single-step polishing step or a polishing step including two or more sub-steps. The final polishing step as referred to herein designates a step of applying final polishing to an object to be polished that experienced stock polishing, specifically, a polishing step set at the end (i.e., on the most downstream) of polishing steps performed with a polishing slurry containing an abrasive. In such a polishing method including the stock polishing step and the final polishing step, the polishing composition disclosed herein may be used in the stock polishing step, may be used in the final polishing step, or may be used in both of the stock polishing step and the final polishing step.

The stock polishing and the final polishing can be applied to polishing using either a single-side polishing machine or a double-side polishing machine. In a single-side polishing machine, one side of an object to be polished is polished by attaching the object to be polished to a ceramic plate with wax or holding the object to be polished with a holder called a carrier, and then pressing the polishing pad against one side of the object to be polished and moving both relative to each other with supplying a polishing composition. This movement is, e.g., rotational movement. In a double-side polishing machine, both sides of an object to be polished are polished simultaneously by holding the object to be polished with a holder called a carrier, and then pressing polishing pads against opposing sides of the object to be polished and rotating them relative to one another with supplying the polishing composition from above.

Conditions of the polishing described above are appropriately set based on the kind of a material to be polished, surface properties of interest (specifically, smoothness), a polishing removal rate and the like, and thus is not limited to particular conditions. For example, with regard to processing pressure, the polishing composition disclosed herein can be used within a wide pressure range of e.g., 10 kPa or more and 150 kPa or less. In view of improving a polishing removal rate, the processing pressure in some embodiments may be, e.g., 5 kPa or more, 10 kPa or more, 20 kPa or more, 30 kPa or more, or 40 kPa or more, and can also be 100 kPa or less, 80 kPa or less, or 60 kPa or less. The polishing composition disclosed herein can also be preferably used in polishing under processing conditions, e.g., with 30 kPa or more or higher, thereby allowing enhancing productivity of a target product derived via the polishing (a polished object). The processing pressure referred to herein is synonymous with polishing pressure.

The polishing pad used in each polishing step disclosed herein is not particularly limited. For example, any of a non-woven fabric type, a suede type, and a hard foamed polyurethane type may be used. In some embodiments, a hard foamed polyurethane type polishing pad may be preferably employed. A polishing pad used in the art disclosed herein is an abrasive-free polishing pad.

An object to be polished that is polished by the method disclosed herein is typically cleaned after polishing. The cleaning can be performed using a suitable cleaning solution. The cleaning solution to be used is not particularly limited, and a known or conventional cleaning solution can be appropriately selected and used.

The polishing method disclosed herein may include any other step in addition to the stock polishing step and final polishing step described above. Examples of such a step include a mechanical polishing step, and a lapping step performed before the stock polishing step. In the mechanical polishing step, an object to be polished is polished with a liquid of a diamond abrasive dispersed in a solvent. In some preferred embodiments, the dispersion contains no oxidant. The lapping step is a step of polishing with pressing a surface of a polishing platen, such as a cast iron platen, to an object to be polished. Therefore, in the lapping step, no polishing pad is used. The lapping step is typically performed by supplying an abrasive between a polishing platen and an object to be polished. The abrasive is typically a diamond abrasive. In addition, the polishing method disclosed herein may include an additional step before the stock polishing step or between the stock polishing step and the final polishing step. The additional step is, e.g., a cleaning step or a polishing step.

<Production Method of Polished Object>

The art disclosed herein may include providing a method of producing a polished object that includes a polishing step with use of any of the polishing methods described above, and a polished object produced by the method. The production method of the polished object is, e.g., a method of producing a silicon carbide substrate. That is, the art disclosed herein provides a method of producing a polished object that includes polishing an object to be polished having a surface formed of a high hardness material by applying any of the polishing methods disclosed herein, and provides a polished object produced by the method. The production method described above can efficiently provide a substrate produced via polishing, such as a silicon carbide substrate.

The items disclosed herein include the followings.

[1] A polishing composition containing resin particles and an oxidant, wherein the oxidant contains a composite metal oxide and wherein the resin particles are contained in amount of 0.01% by weight or more.

[2] The polishing composition set forth in the item [1], wherein the resin particles contain one kind selected from the group consisting of a polyolefin resin, an acrylic resin, a styrene-acrylic resin, a vinyl chloride resin, a melamine resin, a polyurethane resin, and an acrylic-urethane resin.

[3] The polishing composition set forth in the item [2], wherein the resin particles contain a cross-linked acrylic resin.

[4] The polishing composition set forth in the item [2], wherein the resin particles contain a cross-linked styrene-acrylic resin.

[5] The polishing composition set forth in any of the items [1] to [4], further containing inorganic particles.

[6] The polishing composition set forth in the item [5], wherein the inorganic particles contain oxide particles.

[7] The polishing composition set forth in the item [6], wherein the oxide particles contain alumina.

[8] The polishing composition set forth in the item [6], wherein the oxide particles contain silica.

[9] The polishing composition set forth in any of the items [1] to [8], wherein the polishing composition has a pH of 9 or less.

[10] The polishing composition set forth in any of the items [1] to [9], wherein the composite metal oxide is a permanganate.

[11] The polishing composition set forth in any of the items [1] to [10], wherein the amount of the resin particles is 1% by weight or less.

[12] The polishing composition set forth in any of the items [1] to [11], wherein the resin particles have an average particle diameter of 0.005 $\mu$m or more and 3 $\mu$m or less.

[13] The polishing composition set forth in any of the items [1] to [12], in use for polishing of a material having a Vickers hardness of 1500 Hv or more.

[14] The polishing composition set forth in any of the items [1] to [13], in use for polishing of silicon carbide.

[Examples]

Several examples relating to the present invention will be described below, but the present invention is not intended to be limited to the embodiments shown in the examples. In the following description, "%" are on a weight basis unless otherwise specified.

<Preparation of Polishing Composition>

<<Experiment 1>>

(Examples 1 to 13)

Resin particles, an oxidant, inorganic particles, and deionized water were mixed together to prepare a polishing composition. The polishing composition contained 1.6% by weight of the oxidant and 5.9% by weight of the inorganic particles. The content of resin particles in the polishing composition, and the types of the resin particles, the oxidant, and the inorganic particles used were as shown in Table 1.

(Comparative Example 1)

An oxidant, inorganic particles, and deionized water were mixed together to prepare a polishing composition. The polishing composition contained 1.6% by weight of the oxidant and 5.9% by weight of the inorganic particles. The types of the oxidant and the inorganic particles used were as shown in Table 1.

<Polishing of Object to be Polished>

A SiC wafer was stock polished with a stock polishing composition containing alumina particles. The polished SiC wafer was polished under the conditions described below, by directly using the polishing composition of each of the examples as a polishing slurry.

[Polishing Conditions]

Polishing machine: model "RDP-500", manufactured by Fujikoshi Machinery Corp.
Polishing pad: "SUBA800XY", manufactured by Nitta Haas Incorporated. (non-woven fabric type)
Polishing pressure: 29.4 kPa
Platen rotational speed: 100 revolutions/min
Head rotational speed: 100 revolutions/min
Supply flow rate of polishing slurry: 20 mL/min
Usage of polishing slurry: one-way
Polishing time: 1 hour
Object to be polished: 1 inch SiC wafer (conduction type: n-type, crystalline type: 4H-SiC, off angle to the C-axis of the main surface (0001): 4°), Si surface, 1 sheet/batch
Temperature of polishing slurry: 23°C

<Measurement and Evaluation>

(Polishing Removal Rate)

A SiC wafer was polished with the polishing composition of each of the examples under the polishing conditions described above, and then a polishing removal rate was calculated in accordance with the formulae (1) and (2). The density of SiC was 3.21 g/cm$^3$, and the polishing area was 19.62 cm$^2$.

Polishing removal [cm] = difference in weight of SiC wafer before and after polishing [g]/density of SiC [g/cm$^3$]/ polishing area [cm$^2$]     (1)

$$(2) \text{ Polishing removal rate [nm/h]} = \text{polishing removal [cm]} \times 10^7/\text{polishing time [h]}$$

The results thus obtained were converted to relative values with defining the polishing removal rate for Comparative Example 1 as 100%. A larger value represents a better polishing removal rate.

[Table 1]

Table 1

| | | Resin particles | | | Oxidant | Inorganic particles | | pH | Polishing removal rate (ratio) |
|---|---|---|---|---|---|---|---|---|---|
| | | Type | Average particle diameter [μm] | Content [wt%] | Type | Type | Average primary particle diameter [nm] | | |
| Example 1 | | cross-linked acrylic resin | 0.02 | 0.016 | potassium permanganate | α-alumina | 440 | 6.2 | 114 |
| Example 2 | | cross-linked acrylic resin | 0.02 | 0.032 | potassium permanganate | α-alumina | 440 | 6.4 | 118 |
| Example 3 | | cross-linked acrylic resin | 0.02 | 0.064 | potassium permanganate | α-alumina | 440 | 6.9 | 126 |
| Example 4 | | cross-linked acrylic resin | 0.02 | 0.128 | potassium permanganate | α-alumina | 440 | 7.4 | 126 |
| Example 5 | | cross-linked acrylic resin | 0.02 | 0.192 | potassium permanganate | α-alumina | 440 | 7.7 | 122 |
| Example 6 | | cross-linked acrylic resin | 0.45 | 0.016 | potassium permanganate | α-alumina | 440 | 5.9 | 109 |
| Example 7 | | cross-linked acrylic resin | 0.45 | 0.032 | potassium permanganate | α-alumina | 440 | 6.0 | 109 |
| Example 8 | | cross-linked acrylic resin | 0.45 | 0.064 | potassium permanganate | α-alumina | 440 | 6.4 | 114 |
| Example 9 | | acrylic cross-linked material | 9.7 | 0.016 | potassium permanganate | α-alumina | 440 | 5.7 | 109 |
| Example 10 | | cross-linked acrylic resin (low Tg) | 0.8 | 0.032 | potassium permanganate | α-alumina | 440 | 6.7 | 103 |
| Example 11 | | urethane resin(Tg -13°C) | 7.5 | 0.016 | potassium permanganate | α-alumina | 440 | 6.4 | 110 |
| Example 12 | | urethane resin(Tg -52°C) | 6.9 | 0.016 | potassium permanganate | α-alumina | 440 | 6.3 | 103 |
| Example 13 | | melamine-formaldehyde condensate | 0.1 | 0.128 | potassium permanganate | α-alumina | 440 | 8.0 | 107 |
| Comperative Example 1 | | none | - | - | potassium permanganate | α-alumina | 440 | 5.8 | 100 |

As shown in Table 1, polishing compositions in the examples containing 0.01% by weight or more of resin particles enabled greater improvement in a polishing removal rate compared to the polishing composition in Comparative Example 1.

<<Experiment 2>>

(Examples 14 to 17)

Resin particles, an oxidant, inorganic particles, a metal salt, and deionized water were mixed together to prepare a polishing composition. The polishing composition contained 4% by weight of the oxidant, 0.1% by weight of the inorganic particles, and 30 mmol/L of the metal salt. The content of the resin particles in the polishing composition, and the types of the resin particles, the oxidant, the inorganic particles, and a metal salt used were as shown in Tables 2 and Table 3.

(Comparative Example 2 and Comparative Example 3)

An oxidant, inorganic particles, a metal salt, and deionized water were mixed together to prepare a polishing composition. The polishing composition contained 4% by weight of the oxidant, 0.1% by weight of the inorganic particles, and 30 mmol/L of the metal salt. The types of the oxidant, the inorganic particles, and the metal salt used were as shown in Table 2 and Table 3.

<Polishing of Object to be Polished>

A SiC wafer was stock polished with a stock polishing composition containing alumina particles. The polished SiC wafer was polished under the conditions described below, by directly using the polishing composition of each of the examples as a polishing slurry.

[Polishing Conditions]

Polishing machine: model "RDP-500", manufactured by Fujikoshi Machinery Corp.
Polishing pad: "SUBA800XY", manufactured by Nitta Haas Incorporated. (non-woven fabric type)
Polishing pressure: 29.4 kPa
Platen rotational speed: 100 revolutions/min
Head rotational speed: 100 revolutions/min
Supply flow rate of polishing slurry: 20 mL/min
Usage of polishing slurry: one-way
Polishing time: 1 hour
Object to be polished: 1 inch SiC wafer (conduction type: n-type, crystalline type: 4H-SiC, off angle to the C-axis of the main surface (0001): 4°), Si surface, 1 sheet/batch
Temperature of polishing slurry: 23°C

<Measurement and Evaluation>

(Polishing Removal Rate)

A SiC wafer was polished with the polishing composition of each of the examples under the polishing conditions described above, and then a polishing removal rate was calculated in accordance with the formulae (1) and (2). The density of SiC was 3.21 $g/cm^3$, and the polishing area was 19.62 $cm^2$.

Polishing removal [cm] = difference in weight of SiC wafer before and after polishing [g]/density of SiC [$g/cm^3$]/ polishing area [$cm^2$]　　　(1)

$$(2)\ \text{Polishing removal rate [nm/h]} = \text{polishing removal [cm]} \times 10^7/\text{polishing time [h]}$$

The results obtained with use of the polishing compositions in Examples 14 to 16 were converted to relative values with defining the polishing removal rate for Comparative Example 2 as 100%. The result obtained with use of the polishing composition in Example 17 was converted to a relative value with defining the polishing removal rate for Comparative Example 3 as 100%. A larger value represents a better polishing removal rate.

[Table 2]

Table 2

| | Resin particles | | | Oxidant | Inorganic particles | | Metal salt | pH | Polishing removal rate (ratio) |
|---|---|---|---|---|---|---|---|---|---|
| | Type | Average particle diameter [μm] | Content [wt%] | Type | Type | Average primary particle diameter [nm] | Type | | |
| Example 14 | cross-linked acrylic resin | 0.02 | 0.064 | potassium permanganate | α-alumina | 310 | aluminum nitrate | 3.4 | 102 |
| Example 15 | cross-linked acrylic resin | 0.45 | 0.064 | potassium permanganate | α-alumina | 310 | aluminum nitrate | 3.7 | 102 |
| Example 16 | acrylic cross-linked material | 9.7 | 0.016 | potassium permanganate | α-alumina | 310 | aluminum nitrate | 3.4 | 106 |
| Comperative Example 2 | none | - | - | potassium permanganate | α-alumina | 310 | aluminum nitrate | 3.4 | 100 |

EP 4 693 375 A1

[Table 3]

Table 3

|  | Resin particles | | | Oxidant | Inorganic particles | | Metal salt | pH | Polishing removal rate (ratio) |
|---|---|---|---|---|---|---|---|---|---|
|  | Type | Average particle diameter [μm] | Content [wt%] | Type | Type | Average primary particle diameter [nm] | Type |  |  |
| Example 17 | acrylic cross-linked material | 9.7 | 0.016 | potassium permanganate | silica particles | 64 | aluminum nitrate | 3.4 | 105 |
| Comperative Example 3 | none | - | - | potassium permanganate | silica particles | 64 | aluminum nitrate | 3.3 | 100 |

As shown in Table 2, the polishing compositions in Examples 14 to 16 containing 0.01% by weight or more of resin particles enabled greater improvement in a polishing removal rate compared to the polishing composition in Comparative Example 2. Meanwhile, as shown in Table 3, the polishing composition in Example 17 containing 0.01% by weight or more of resin particles enabled greater improvement in a polishing removal rate compared to the polishing composition in Comparative Example 3.

## Claims

1. A polishing composition comprising resin particles and an oxidant,

   wherein the oxidant comprises a composite metal oxide, and
   wherein the resin particles are contained in an amount of 0.01% by weight or more.

2. The polishing composition according to claim 1, wherein the resin particles comprise one kind selected from the group consisting of a polyolefin resin, an acrylic resin, a styrene-acrylic resin, a vinyl chloride resin, a melamine resin, a polyurethane resin, and an acrylic-urethane resin.

3. The polishing composition according to claim 2, wherein the resin particles comprise a cross-linked acrylic resin.

4. The polishing composition according to claim 2, wherein the resin particles comprise a cross-linked styrene-acrylic resin.

5. The polishing composition according to claim 1, further comprising inorganic particles.

6. The polishing composition according to claim 5, wherein the inorganic particles comprise oxide particles.

7. The polishing composition according to claim 6, wherein the oxide particles comprise alumina.

8. The polishing composition according to claim 6, wherein the oxide particles comprise silica.

9. The polishing composition according to claim 1, wherein the polishing composition has a pH of 9 or less.

10. The polishing composition according to claim 1, wherein the composite metal oxide is a permanganate.

11. The polishing composition according to claim 1, wherein the amount of the resin particles is 1% by weight or less.

12. The polishing composition according to claim 1, wherein the resin particles have an average particle diameter of 0.005

μm or more and 3 μm or less.

13. The polishing composition according to claim 1, in use for polishing of a material having a Vickers hardness of 1500 Hv or more.

14. The polishing composition according to claim 1, in use for polishing of silicon carbide.

## INTERNATIONAL SEARCH REPORT

| | International application No. |
|---|---|
| | **PCT/JP2024/011420** |

**A.    CLASSIFICATION OF SUBJECT MATTER**

*H01L 21/304*(2006.01)i; *C09G 1/02*(2006.01)i; *C09K 3/14*(2006.01)i
FI:    H01L21/304 622D; C09K3/14 550Z; C09K3/14 550D; C09G1/02

According to International Patent Classification (IPC) or to both national classification and IPC

**B.    FIELDS SEARCHED**

Minimum documentation searched (classification system followed by classification symbols)

H01L21/304; C09G1/02; C09K3/14

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | JP 2004-128475 A (JSR CORPORATION) 22 April 2004 (2004-04-22) paragraphs [0009]-[0098] | 1-13 |
| A | | 14 |
| X | JP 2005-518670 A (APPLIED MATERIALS, INCORPORATED) 23 June 2005 (2005-06-23) paragraphs [0009]-[0098] | 1-14 |
| X | JP 2015-523716 A (BASF SE) 13 August 2015 (2015-08-13) paragraphs [0017]-[0119] | 1-13 |
| A | | 14 |
| A | JP 2005-302973 A (JSR CORPORATION) 27 October 2005 (2005-10-27) entire text, all drawings | 1-14 |
| A | JP 2005-142516 A (DOI, Toshiro) 02 June 2005 (2005-06-02) entire text, all drawings | 1-14 |

☑ Further documents are listed in the continuation of Box C.     ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **03 June 2024** | **11 June 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**

International application No.

**PCT/JP2024/011420**

| C. | DOCUMENTS CONSIDERED TO BE RELEVANT | |
|---|---|---|
| Category* | Citation of document, with indication, where appropriate, of the relevant passages | Relevant to claim No. |
| A | JP 2006-310362 A (SUMITOMO ELECTRIC INDUSTRIES, LTD.) 09 November 2006 (2006-11-09)<br>entire text, all drawings | 1-14 |
| A | US 2017/0110333 A1 (INTERNATIONAL BUSINESS MACHINES CORP.) 20 April 2017 (2017-04-20)<br>entire text, all drawings | 1-14 |

## INTERNATIONAL SEARCH REPORT
### Information on patent family members

International application No.

**PCT/JP2024/011420**

| Patent document cited in search report | | | Publication date (day/month/year) | Patent family member(s) | | | Publication date (day/month/year) |
|---|---|---|---|---|---|---|---|
| JP | 2004-128475 | A | 22 April 2004 | US | 2004/0162011 | A1 | |
| | | | | paragraphs [0011]-[0199] | | | |
| | | | | EP | 1386949 | A2 | |
| | | | | KR | 10-2004-0012588 | A | |
| | | | | CN | 1495244 | A | |
| | | | | TW | 200403131 | A | |
| JP | 2005-518670 | A | 23 June 2005 | US | 2003/0178320 | A1 | |
| | | | | paragraphs [0015]-[0113] | | | |
| | | | | CN | 1646649 | A | |
| | | | | KR | 10-2004-0093725 | A | |
| | | | | TW | 200416271 | A | |
| JP | 2015-523716 | A | 13 August 2015 | US | 2015/0175845 | A1 | |
| | | | | paragraphs [0021]-[0196] | | | |
| | | | | TW | 201402736 | A | |
| | | | | CN | 104364331 | A | |
| | | | | KR | 10-2015-0014982 | A | |
| JP | 2005-302973 | A | 27 October 2005 | US | 2005/0227451 | A1 | |
| | | | | entire text, all drawings | | | |
| | | | | EP | 1586614 | A1 | |
| | | | | TW | 200537614 | A | |
| | | | | KR | 10-2006-0047159 | A | |
| | | | | CN | 1683465 | A | |
| JP | 2005-142516 | A | 02 June 2005 | (Family: none) | | | |
| JP | 2006-310362 | A | 09 November 2006 | US | 2006/0236922 | A1 | |
| | | | | entire text, all drawings | | | |
| | | | | EP | 1717286 | A1 | |
| | | | | KR | 10-2006-0112232 | A | |
| | | | | CN | 1868674 | A | |
| | | | | TW | 200731381 | A | |
| US | 2017/0110333 | A1 | 20 April 2017 | (Family: none) | | | |

Form PCT/ISA/210 (patent family annex) (July 2022)

23

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023056599 A

- WO 2016072370 A